(19) Europäisches Patentamt
European Patent Office
Office européen des brevets

(11) EP 4 372 826 A1

(12) **EUROPEAN PATENT APPLICATION**
published in accordance with Art. 153(4) EPC

(43) Date of publication:
**22.05.2024 Bulletin 2024/21**

(21) Application number: **22855351.7**

(22) Date of filing: **05.08.2022**

(51) International Patent Classification (IPC):
*H01L 29/45* (2006.01)        *H01L 29/778* (2006.01)
*H01L 21/285* (2006.01)        *H01L 21/335* (2006.01)

(52) Cooperative Patent Classification (CPC):
**H01L 21/285; H01L 29/45; H01L 29/66409; H01L 29/778**

(86) International application number:
**PCT/CN2022/110564**

(87) International publication number:
**WO 2023/016370 (16.02.2023 Gazette 2023/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.08.2021 CN 202110913394**

(71) Applicant: **Huawei Technologies Co., Ltd.
Shenzhen, Guangdong 518129 (CN)**

(72) Inventors:
• **WANG, Xin
Shenzhen, Guangdong 518129 (CN)**
• **ZHANG, Dongliang
Shenzhen, Guangdong 518129 (CN)**
• **WANG, Dongsheng
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **SEMICONDUCTOR DEVICE AND PREPARATION METHOD THEREFOR**

(57)    This application relates to the field of electronic device technologies, and specifically, to a semiconductor device and a preparation method thereof. The semiconductor device includes: a substrate; an epitaxial structure disposed on the substrate; a passivation layer disposed on the epitaxial structure; and an ohmic contact electrode disposed in parallel with the passivation layer on the epitaxial structure, where the ohmic contact electrode includes a non-contact layer and a contact layer that are disposed in a laminated manner, the contact layer is in contact with the epitaxial structure, and composition elements of the contact layer include a germanium element and a tantalum element. The semiconductor device has a low ohmic contact resistance.

FIG. 3

EP 4 372 826 A1

**Description**

This application claims priority to Chinese Patent Application No. 202110913394.X, filed with the China National Intellectual Property Administration on August 10, 2021 and entitled "SEMICONDUCTOR DEVICE AND PREPARATION METHOD THEREOF", which is incorporated herein by reference in its entirety.

**TECHNICAL FIELD**

This application relates to the field of electronic device technologies, and specifically, to a semiconductor device and a preparation method thereof.

**BACKGROUND**

A semiconductor device is an electronic device whose conductivity is between a good conductor and an insulator, and uses a special electrical characteristic of a semiconductor material to perform a specific function. The semiconductor device has a purpose of generating, controlling, receiving, converting, and amplifying a signal, converting energy, and the like. Therefore, the semiconductor device is widely used in a plurality of fields. For example, in the field of wireless communications, a semiconductor device may be used as a power amplifier (power amplifier, PA). In the field of wireless charging, a semiconductor device may be used as a power device of a power adapter.

At present, with development of technologies such as a communication technology and a wireless charging technology, a semiconductor device with better performance is urgently needed.

**SUMMARY**

Embodiments of this application provide a semiconductor device and a preparation method thereof, to avoid or reduce an application limitation of the semiconductor device in a low-voltage field.

According to a first aspect, an embodiment of this application provides a semiconductor device, including: a substrate; an epitaxial structure disposed on the substrate; a passivation layer disposed on the epitaxial structure; and an ohmic contact electrode disposed in parallel with the passivation layer on the epitaxial structure, where the ohmic contact electrode includes a non-contact layer and a contact layer that are disposed in a laminated manner, the contact layer is in contact with the epitaxial structure, and composition elements of the contact layer include a germanium element and a tantalum element.

In the semiconductor device provided in this embodiment of this application, the tantalum element in the contact layer is used as a metal element to form an ohmic contact with the epitaxial structure. The germanium element in the contact layer can increase electron tunneling effect between the contact layer and the epitaxial structure, and can provide more electrons that can cross a barrier between the contact layer and the epitaxial structure. This reduces a resistance between the ohmic contact electrode and the epitaxial structure, to reduce an ohmic contact resistance of the semiconductor device. In addition, the tantalum element in the contact layer can reduce an annealing temperature of the contact layer, so that the annealing temperature can reach below 600°C, to help improve surface quality of a contact interface between the contact layer and the epitaxial structure. A contact interface with high surface quality can further reduce the resistance between the ohmic contact electrode and the epitaxial structure, and can improve thermal stability and reliability of the semiconductor device.

In a possible implementation, the contact layer includes a germanium tantalum alloy.

In this implementation, the contact layer includes the germanium tantalum alloy, and atoms of the germanium element and the tantalum element in the germanium tantalum alloy are more evenly distributed, so that the germanium element increases the electron tunneling effect between the contact layer and the epitaxial structure, and provides more electrons that can cross the barrier between the contact layer and the epitaxial structure, to facilitate diffusion of the tantalum element to the epitaxial structure, and reduce resistance between the contact layer and the epitaxial structure. In addition, the tantalum element can reduce an annealing temperature of the ohmic contact electrode and improve the surface quality of the contact interface. This further reduces the ohmic contact electrode of the semiconductor device, and improves the thermal stability and the reliability of the semiconductor device.

In a possible implementation, element composition of the germanium tantalum alloy is shown in formula (I):

$$Ge_x Ta_{1-x} \qquad (I),$$

where
$0.5 \geq x \geq 0.1$.

In this implementation, a ratio of a quantity of germanium elements to a quantity of tantalum elements in the germanium tantalum alloy is set, so that when the germanium element is used to increase the electron tunneling effect between the contact layer and the epitaxial structure as much as possible, more electrons that can cross the barrier between the contact layer and the epitaxial structure are provided, to facilitate diffusion of the tantalum element to the epitaxial structure, and reduce the resistance between the contact layer and the epitaxial structure. In addition, an appropriate quantity of tantalum elements can effectively reduce the annealing temperature of the ohmic contact electrode, and improve the surface quality of the contact interface, to further reduce the resistance between the ohmic contact electrode and the epitaxial structure, and improve the thermal stability and the reliability of the semiconductor device.

In a possible implementation, the contact layer includes at least one germanium layer, and the contact layer is in contact with the epitaxial structure by using a first germanium layer of the at least one germanium layer.

In this implementation, the germanium layer is in contact with the epitaxial structure, so that the electron tunneling effect between the contact layer and the epitaxial structure can be further increased, more electrons that can cross the barrier between the contact layer and the epitaxial structure can be provided, and the resistance between the ohmic contact electrode and the epitaxial structure can be reduced. In addition, the contact layer is in contact with the epitaxial structure by using the germanium layer, so that an interface between the contact layer and the epitaxial structure is sharp, and surface quality between the ohmic contact electrode and the epitaxial structure can be improved. This further reduces the resistance between the ohmic contact electrode and the epitaxial structure, and improves the thermal stability and the reliability of the semiconductor device.

In a possible implementation, the contact layer further includes at least one tantalum layer, where the at least one germanium layer and the at least one tantalum layer are interleaved in a laminated manner.

In this implementation, the at least one germanium layer and the at least one tantalum layer are interleaved in a laminated manner, and germanium atoms in the germanium layer and tantalum atoms in the tantalum layer that are adjacent to each other may diffuse with each other, so that the electron tunneling effect between the contact layer and the epitaxial structure is increased by using the germanium element, more electrons that can cross the barrier between the contact layer and the epitaxial structure are provided, and the tantalum element may also be used to reduce the annealing temperature of the ohmic contact electrode, and improve the surface quality of the contact interface, to further reduce the ohmic contact electrode of the semiconductor device, and improve the thermal stability and the reliability of the semiconductor device. In this implementation, a preparation manner of interleaving the at least one germanium layer and the at least one tantalum layer in a laminated manner is simpler and easier to implement. This facilitates industrial production of the semiconductor device.

In a possible implementation, a ratio of the germanium element to the tantalum element is less than or equal to 50%.

In this implementation, a ratio of a quantity of germanium elements to a quantity of tantalum elements in the contact layer is set, to facilitate diffusion of the tantalum element to the epitaxial structure, and reduce the resistance between the contact layer and the epitaxial structure. In addition, the electron tunneling effect between the contact layer and the epitaxial structure may be increased as much as possible by using the germanium element, and more electrons that can cross the barrier between the contact layer and the epitaxial structure are provided. In addition, an appropriate quantity of tantalum elements can effectively reduce the annealing temperature of the ohmic contact electrode, and improve the surface quality of the contact interface, to further reduce the resistance between the ohmic contact electrode and the epitaxial structure, and improve the thermal stability and the reliability of the semiconductor device.

In a possible implementation, the contact layer includes elements Ge, Ta, and A, where A is any one of the following:

Ti, Al, Pt, Au, Ni, Mo, and W.

In this implementation, the A element participates in composition of the contact layer, and the A element may catalyze Ge and Ta to form an alloy with more uniform atom distribution, so that when the germanium element increases the electron tunneling effect between the contact layer and the epitaxial structure, and provides more electrons that can cross the barrier between the contact layer and the epitaxial structure, the tantalum element can reduce the annealing temperature of the ohmic contact electrode, and improve the surface quality of the contact interface. In addition, when the contact layer is in contact with a barrier layer in the epitaxial result, the A element may further optimize element distribution between the contact layer and the barrier layer, increase a band gap width of the barrier layer, and increase a concentration of a two-dimensional electron gas, to further reduce the ohmic contact resistance.

In a possible implementation, the contact layer includes an alloy formed by the elements Ge, Ta, and A.

In this implementation, the contact layer includes the alloy formed by the elements Ge, Ta, and A, and elements in the alloy are distributed more evenly. In addition, the A element can further improve uniformity of atom distribution of the germanium element and the tantalum element in the germanium tantalum alloy, so that when the germanium element increases the electron tunneling effect between the contact layer and the epitaxial structure, and provides more electrons that can cross the barrier between the contact layer and the epitaxial structure, the tantalum element can reduce the annealing temperature of the ohmic contact electrode, and improve the surface quality of the contact interface. This further reduces the ohmic contact electrode of the semiconductor device, and improves the thermal stability and the reliability of the semiconductor device.

In a possible implementation, element composition of the alloy formed by the elements Ge, Ta, and A is shown in formula (II):

$$Ge_xA_yTa_{1-x-y} \text{ alloy} \qquad (II),$$

where

$0.5 \geq x \geq 0.1$, and $0.1 \geq y > 0$.

In this implementation, a proportion of elements in the $Ge_xA_yTa_{1-x-y}$ alloy is set, and the A element may catalyze germanium and tantalum to form an alloy with more uniform atomic distribution, to facilitate diffusion of the tantalum element to the epitaxial structure, and reduce the resistance between the contact layer and the epitaxial structure. In addition, the electron tunneling effect between the contact layer and the epitaxial structure may be increased as much as possible by using the germanium elements, and more electrons that can cross the barrier between the contact layer and the epitaxial structure are provided. In addition, an appropriate quantity of tantalum elements can effectively reduce the annealing temperature of the ohmic contact electrode, and improve the surface quality of the contact interface, to further reduce the resistance between the ohmic contact electrode and the epitaxial structure, and improve the thermal stability and the reliability of the semiconductor device.

In a possible implementation, the epitaxial structure includes: a first semiconductor layer located above the substrate; and a second semiconductor layer located between the first semiconductor layer and the substrate and in contact with the first semiconductor layer, where a two-dimensional electron gas is disposed on a side that is of the second semiconductor layer and that is close to the first semiconductor layer, where a distance between the contact layer and the second semiconductor layer in a vertical direction is less than a height of the first semiconductor layer in the vertical direction. For example, the first semiconductor layer is a barrier layer, and the second semiconductor layer is a buffer layer.

In this implementation, the distance between the contact layer and the second semiconductor is less than a thickness of the first semiconductor, so that the contact layer is closer to the two-dimensional electron gas in the second semiconductor. This increases a probability of electron tunneling between the ohmic contact electrode and the two-dimensional electron gas, and reduces the resistance between the ohmic contact electrode and the epitaxial structure, to reduce the ohmic contact resistance of the semiconductor device.

In a possible implementation, the epitaxial structure includes: a first semiconductor layer located above the substrate; and a second semiconductor layer located between the first semiconductor layer and the substrate and in contact with the first semiconductor layer, where a two-dimensional electron gas is disposed on a side that is of the second semiconductor layer and that is close to the first semiconductor layer, where the contact layer runs through the first semiconductor layer and is in contact with the second semiconductor layer. For example, the first semiconductor layer is a barrier layer, and the second semiconductor layer is a buffer layer.

In this implementation, the contact layer is directly connected to the second semiconductor layer having the two-dimensional electron gas, so that the contact layer is closer to the two-dimensional electron gas. This further increases a probability of electron tunneling between the ohmic contact electrode and the two-dimensional electron gas, and further reduces the resistance between the ohmic contact electrode and the epitaxial structure, to reduce the ohmic contact resistance of the semiconductor device.

In a possible implementation, a distance between the contact layer and the substrate in a vertical direction is less than a thickness of the second semiconductor layer.

In this implementation, the contact layer is further close to the two-dimensional electronic gas, or even directly contacts the two-dimensional electronic gas. This further increases a probability of electron tunneling between the ohmic contact electrode and the two-dimensional electronic gas, and further reduces the resistance between the ohmic contact electrode and the epitaxial structure, to reduce the ohmic contact resistance of the semiconductor device.

In a possible implementation, the second semiconductor layer is gallium nitride, and the first semiconductor layer is any one of AlGaN, InAlN, InAlGaN, AlN, ScAlN, and ScAlGaN; or the second semiconductor layer is gallium arsenide, and the first semiconductor layer is InGaAs or AlGaAs.

In this implementation, an ohmic contact resistance of a gallium nitride component may be reduced, and the gallium nitride component having a low ohmic contact resistance may be provided, so that the gallium nitride component may be used in the low-voltage field; or an ohmic contact resistance of a gallium arsenide component may be reduced, and the gallium arsenide component having a low ohmic contact resistance may be provided, to optimize performance of the gallium arsenide component.

In a possible implementation, the non-contact layer includes a blocking layer, and the blocking layer includes any one of the tantalum element, a titanium element, a nickel element, and a molybdenum element.

In this implementation, the blocking layer can improve adhesion between the ohmic contact electrode and the epitaxial structure, and reduce a possibility that the ohmic contact electrode is detached from the epitaxial structure.

In a possible implementation, the ohmic contact electrode is a source electrode or a drain electrode of the semiconductor device.

In this implementation, the ohmic contact electrode is used as the source electrode or the drain electrode of the semiconductor device. This reduces a resistance between the epitaxial structure of the semiconductor device and the source electrode, or reduces a resistance between the epitaxial structure of the semiconductor device and the drain electrode, reduces the ohmic contact resistance of the semiconductor device, and improves performance of the semiconductor device.

According to a second aspect, an embodiment of this application provides a semiconductor device preparation method, including: growing an epitaxial structure on a substrate; and depositing a contact layer of an ohmic contact electrode on the epitaxial structure, where composition elements of the contact layer include a germanium element and a tantalum element.

In a semiconductor device prepared by using the method, the ohmic contact electrode is in contact with the epitaxial structure by using the contact layer including the germanium element. The germanium element may increase electron tunneling effect between the contact layer and the epitaxial structure, provide more electrons that can cross a barrier between the contact layer and the epitaxial structure, and reduce a resistance between the ohmic contact electrode and the epitaxial structure. In addition, the method is simple and easy to implement, and can implement mass production of the semiconductor devices with the low ohmic contact resistance.

In a possible implementation, the epitaxial structure includes: a first semiconductor layer located above the substrate, and a second semiconductor layer located between the first semiconductor layer and the substrate and in contact with the first semiconductor layer, where a two-dimensional electron gas is disposed on a side that is of the second semiconductor layer and that is close to the first semiconductor layer; the method further includes: etching a first part of the first semiconductor layer, to reduce a height of the first part in a vertical direction; and the depositing a contact layer of an ohmic contact electrode on the epitaxial structure includes: depositing the contact layer on the first part.

In the semiconductor device prepared in this implementation, the contact layer is closer to the two-dimensional electronic gas. This further increases a probability of electron tunneling between the ohmic contact electrode and the two-dimensional electronic gas, and further reduces the resistance between the ohmic contact electrode and the epitaxial structure, to reducing the ohmic contact resistance of the semiconductor device.

In a possible implementation, the epitaxial structure includes: a first semiconductor layer located above the substrate, and a second semiconductor layer located between the first semiconductor layer and the substrate and in contact with the first semiconductor layer, where a two-dimensional electron gas is disposed on a side that is of the second semiconductor layer and that is close to the first semiconductor layer; and the depositing a contact layer of an ohmic contact electrode on the epitaxial structure includes: removing a first part that is in contact with a first area of the second semiconductor layer and that is in the first semiconductor layer; and depositing the contact layer on the first area.

In the semiconductor device prepared in this implementation, the contact layer is further close to the two-dimensional electronic gas. This further increases a probability of electron tunneling between the ohmic contact electrode and the two-dimensional electron gas, and further reduces the resistance between the ohmic contact electrode and the epitaxial structure, to reduce the ohmic contact resistance of the semiconductor device.

The semiconductor device provided in this embodiment of this application has a low ohmic contact resistance, and has high thermal stability and reliability. In addition, the semiconductor device preparation method provided in this embodiment of this application is simple and easy to implement. This reduces production costs and a production cycle of a low ohmic contact resistance semiconductor device, and implements mass production of the low ohmic contact resistance semiconductor device.

BRIEF DESCRIPTION OF DRAWINGS

FIG. 1 is a schematic diagram of a resistance between a source electrode and a drain electrode of a semiconductor device;
FIG. 2 is a schematic diagram of a structure of a semiconductor device according to an embodiment of this application;
FIG. 3 is a schematic diagram of a structure of a semiconductor device according to an embodiment of this application;
FIG. 4 is a flowchart of a semiconductor device preparation method according to an embodiment of this application;
FIG. 5 is a schematic diagram of a structure of a semiconductor device according to an embodiment of this application;
FIG. 6 is a flowchart of a semiconductor device preparation method according to an embodiment of this application;
FIG. 7 is a schematic diagram of a structure of a semiconductor device according to an embodiment of this application;
FIG. 8 is a schematic diagram of a structure of a semiconductor device according to an embodiment of this application; and
FIG. 9 is a schematic diagram of a structure of a semiconductor device according to an embodiment of this application.

**DESCRIPTION** OF EMBODIMENTS

The following describes technical solutions of embodiments in this application with reference to accompanying drawings. It is clear that the described embodiments are merely some but not all of embodiments of this application.

A source electrode and a drain electrode of a semiconductor device may be made of a metal material, and there is an ohmic contact resistance between the source electrode and the drain electrode and an epitaxial structure (made of a semiconductor material) of the semiconductor device. The ohmic contact resistance is an important part of the resistance between the source electrode and the drain electrode of the semiconductor device, and the ohmic contact resistance is important for performance of the semiconductor device. The ohmic contact resistance refers to a resistance encountered when electrons flow from a metal to a semiconductor or from a semiconductor to a metal. Specifically, there is a high barrier between the semiconductor and the metal. When doping density of the semiconductor is high, the electrons may pass through the barrier by using tunneling effect, to form an ohmic contact with a low resistance. The low resistance is the ohmic contact resistance.

The source electrode and the drain electrode may be an ohmic contact electrode respectively. In other words, one ohmic contact electrode may be used as the source electrode, and another ohmic contact electrode may be used as the drain electrode. In addition, in the following description, the source electrode and the drain electrode may be referred to as ohmic contact electrodes for short when the source electrode and the drain electrode are not specially distinguished.

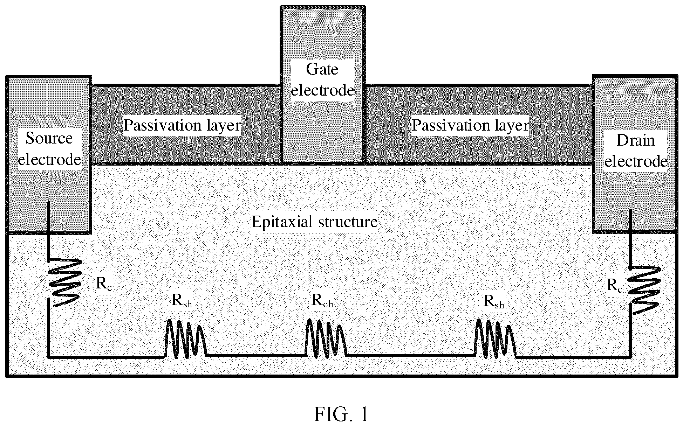

FIG. 1 is a schematic diagram of a resistance between a source electrode and a drain electrode of a semiconductor device. A resistance encountered when a current flows between the source electrode and the drain electrode may be referred to as an on-resistance. The on-resistance may be represented by $R_{on}$, and the ohmic contact resistance may be represented by $R_c$. Referring to FIG. 1 and formula (1), the on-resistance $R_{on}$ is formed by the ohmic contact resistance $R_c$, a square resistance, and a channel resistance. The channel resistance is a product obtained by multiplying a channel resistivity $R_{ch}$ by a channel length $L_{ch}$, and the square resistance is a product obtained by multiplying the square resistivity $R_{sh}$ by a square length. The square length is a difference obtained by subtracting the channel length $L_{ch}$ from a distance $L_{sd}$ between the source electrode and the drain electrode.

$$R_{on}=2R_c+R_{ch}*L_{ch}+R_{sh}*(L_{sd}-L_{ch}) \tag{1}$$

As a third generation semiconductor device, a gallium nitride (gallium nitride, GaN) component has large band gap width and high efficiency. These performances are required by development of a wireless communications technology. Compared with a gallium arsenide (gallium arsenide, GaAs) component, the gallium nitride component can meet requirements of a wireless communications device for a large frequency bandwidth and high efficiency without a need of a multi-level link and an increase in a board area. In addition, the gallium nitride component has an excellent switching speed, which is required by development of a charging technology. Currently, an ohmic contact resistance of the gallium nitride component is large, and application of the gallium nitride component in a low-voltage field (for example, a radio frequency field of a terminal device or a low-voltage charging field) is limited. Especially, due to limitation of a process node (integrated circuit technique) and a size of the component, the ohmic contact resistance of the gallium nitride component is up to 0.5 Ω mm, which accounts for more than 30% of the on-resistance.

If the ohmic contact resistance of the gallium nitride component can be further reduced, working efficiency of the gallium nitride component will be improved and power consumption of the gallium nitride component will be reduced. In addition, a smaller the ohmic contact resistance of the gallium nitride component indicates a smaller specific contact resistivity, and a feature length of an active area may be reduced, so that a cell size of a wafer may be further reduced, and an on-resistance and power density of a chip per unit area are optimized. In this way, an application limitation of the gallium nitride component in the low-voltage field can be removed or reduced.

As described above, performance of the gallium nitride component can be improved by reducing the ohmic contact resistance of the gallium nitride component. It may be understood that, for other semiconductor devices such as a gallium arsenide component, reducing the ohmic contact resistance also improves performance of these components. Details are not further described one by one herein.

Usually, there are two research directions for reducing the ohmic contact resistance. One research direction is to improve an ohmic contact electrode. The research direction may include: a solution a: optimizing a thickness and composition of an alloy that forms the ohmic contact electrode; a solution b: optimizing an annealing process of the ohmic contact electrode; and a solution c: optimizing a sputtering process of the ohmic contact electrode, and the like.

A specific solution of the solution a is to prepare the ohmic contact electrode by using a titanium aluminum alloy, to prepare a gallium nitride component with a low ohmic contact resistance. An ohmic contact resistance consistency of the electrode prepared in this solution is poor. In addition, when an electrode is prepared by using a titanium aluminum alloy, annealing needs to be performed at a high temperature (700 to 1000°C), which affects contact between a gate electrode and an epitaxial structure. In short, it is difficult to obtain a gallium nitride component with good thermal stability and high reliability in this solution.

In addition, with respect to the solution b and the solution c, processes are complex, and consequently, preparation costs of the semiconductor device are increased.

Another research direction for reducing ohmic contact is to optimize the epitaxial structure. The research direction may include: a solution 1: performing full etching on a barrier layer in the epitaxial structure; a solution 2: injecting a donor (donor) material into an active area to perform second epitaxy; and a solution 3: improving an epitaxial structure material.

For the solution 1, affected by an etching process, ohmic contact resistance consistency between the source electrode and the drain electrode is poor, and the ohmic contact resistance is also high. With respect to the solution 2, a process is complex, which causes production costs increase and makes it difficult to support mass production.

For solution 2, a specific solution is to perform etching on the epitaxial structure, and then perform second epitaxial growth in an etching area by using N-type doped gallium nitride as a material, to form N-type heavy doping, to reduce the ohmic contact resistance. This solution is complex. In addition, in the second epitaxial growth, re-entering the material growth furnace causes the epitaxial structure to be likely contaminated.

With respect to solution 3, a specific solution of solution 3 is to inject silicon (silicon, Si) ions and/or indium (indium, In) ions into an area that is in the epitaxial structure and that is in contact with an ohmic contact electrode, to form N-type heavy doping, to reduce the ohmic contact resistance. In this solution, annealing at a high temperature (greater than 1000°C) is required to activate the silicon ions and/or indium ions, which reduces surface quality of other areas. In addition, a process of this solution is complex, and mass production is difficult.

An embodiment of this application provides a semiconductor device with a low ohmic contact resistance, including a substrate (substrate), an epitaxial structure disposed on the substrate, and an ohmic contact electrode disposed on an epitaxial structure. The ohmic contact electrode may be in contact with the epitaxial structure by using a contact layer including a germanium (germanium, Ge) element and a tantalum (tantalum, Ta) element, to improve performance of the semiconductor device. Specifically, when the germanium element is deposited on the epitaxial structure, electron tunneling effect between the contact layer and the epitaxial structure can be increased, and more electrons that can cross a barrier between the contact layer and the epitaxial structure can be provided, to reduce an ohmic contact resistance. In addition, the germanium element helps improve surface quality of the contact layer, so that a contact interface between the contact layer and the epitaxial structure remains smooth. In addition, a melting point of the tantalum element is high, which can prevent deterioration of edge sharpness of a contact layer interface caused by annealing and maintain sharpness of the contact layer interface. The tantalum element can promote a more adequate phase reaction between composition elements of the contact layer. In addition, adding the tantalum element can reduce an annealing temperature of the ohmic contact electrode, so that the annealing temperature can reach below 600°C. This helps improve surface quality of the contact interface between the contact layer and the epitaxial structure, and improve thermal stability and reliability of the semiconductor device.

The semiconductor device provided in embodiments of this application may be applied to a wireless communications device, a power adapter, or the like. For example, the semiconductor device provided in embodiments of this application may be used as a power amplifier of the wireless communications device, or may be used as a power device of the power adapter. The wireless communications device may include a base station, a mobile terminal, or the like. The power adapter may be a wireless charging power adapter. It should be noted that the foregoing merely describes an example of an application scope of the semiconductor device provided in embodiments of this application, and does not limit the application scope. An application scope of the semiconductor device is not limited in embodiments of this application.

The following specifically describes the semiconductor device provided in embodiments of this application with reference to the accompanying drawings.

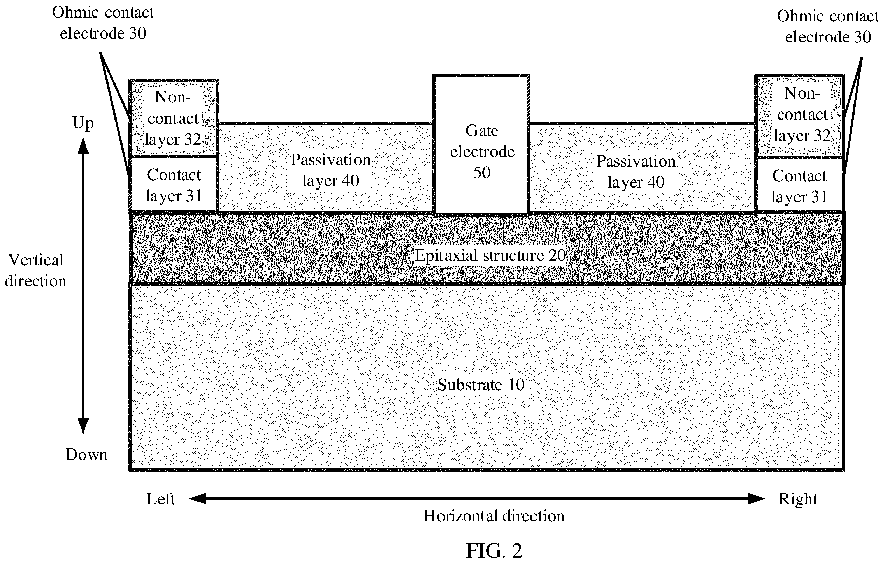

FIG. 2 shows a semiconductor device.

Referring to FIG. 2, the semiconductor device may include a substrate 10. The substrate 10 may also be referred to as a substrate layer, and is a substrate wafer used for epitaxial growth of a semiconductor. Semiconductor epitaxy (epitaxy) is performed on the substrate 10 to grow an epitaxial structure. The substrate 10 has a function of supporting the epitaxial structure and improving a characteristic of the epitaxial structure. In an example, the substrate 10 may be prepared by using silicon (Si). In an example, the substrate 10 may be prepared by using a sapphire (sapphire). In an example, the substrate 10 may be prepared by using silicon carbide (SiC). In an example, the substrate 10 may be prepared by using diamond (diamond).

It may be understood that the substrate 10 is a thin sheet structure. Referring to FIG. 2, in this embodiment of this application, a direction perpendicular to an upper surface (or a lower surface) of the substrate 10 may be referred to as a vertical direction, and a direction parallel to the upper surface (or the lower surface) of the substrate 10 may be referred to as a horizontal direction.

Still referring to FIG. 2, the semiconductor device may further include an epitaxial structure 20 disposed on the substrate 10. The epitaxial structure 20 may also be referred to as an epitaxial wafer (epitaxial wafer) or an epitaxial layer, and is a semiconductor layer deposited on the substrate 10 through epitaxy.

The epitaxial structure 20 is a core area of the semiconductor device, and may include a buffer layer 22 and a barrier layer 21. The buffer layer 22 may be located between the substrate 10 and the barrier layer 21. The buffer layer 22 and the barrier layer 21 may be polarized spontaneously, or may be polarized under an action of an electric field, to generate a two-dimensional electron gas (two-dimensional electron gas, 2DEG) on a side that is of the buffer layer and that is close to the barrier layer. The two-dimensional electron gas may also be referred to as a channel electron, and may move along a length direction of the buffer layer, to conduct a source electrode and a drain electrode. In addition, an area in which the two-dimensional electron gas is located may be referred to as a channel. A part of the channel and the buffer layer that are located on the channel may be referred to as a channel layer. The part that is of the buffer layer and that is located on the channel is a part that is of the buffer layer 22 and that is located between the channel and the barrier layer 21.

The buffer layer 22 and the barrier layer 21 are separately made of semiconductor materials with different large band gap widths. A large band gap width of the barrier layer 21 is greater than a large band gap width of the buffer layer 22, so that when polarization occurs between the buffer layer 22 and the barrier layer 21, the two-dimensional electron gas can be generated on the side that is of the buffer layer 22 and that is close to the barrier layer 21.

In some embodiments, the buffer layer 22 may be made of gallium nitride. The barrier layer 21 may be made of gallium aluminum nitride (AlGaN), or made of aluminum indium nitride (InAlN), or made of aluminum indium nitride (InAlGaN), or made of aluminum nitride (AlN), or made of aluminum nitride (ScAlN), or made of aluminum nitride (ScAl-GaN).

In some embodiments, the buffer layer 22 may be made of gallium arsenide. The barrier layer 21 may be made of indium gallium arsenide (InGaAs) or aluminum gallium arsenide (AlGaAs).

In some embodiments, the epitaxial structure 20 may further include a nucleation layer. The nucleation layer is located between the buffer layer 22 and the substrate 10, and is configured to relieve a lattice stress between the substrate 10 and the epitaxial structure 20.

Still referring to FIG. 2, the semiconductor device may further include an ohmic contact electrode 30. The ohmic contact electrode 30 may be used as a source electrode or a drain electrode of the semiconductor device. The ohmic contact electrode 30 may include a contact layer 31, configured to contact the epitaxial structure 20. In other words, in the semiconductor device, a contact interface is formed between the contact layer 31 and the epitaxial structure 20.

In some embodiments, a thickness of the contact layer 31 is less than or equal to 200 nm and is greater than 0. In an example, a thickness of the contact layer 31 is less than or equal to 100 nm and is greater than 0. In an example, a thickness of the contact layer 31 is greater than 6 nm and less than 60 nm. In an example, a thickness of the contact layer 31 is 10 nm. In an example, a thickness of the contact layer 31 is 20 nm. In an example, a thickness of the contact layer 31 is 30 nm. In an example, a thickness of the contact layer 31 is 40 nm. In an example, a thickness of the contact layer 31 is 50 nm.

It may be clear that, as shown in FIG. 2, the thickness of the contact layer 31 is a height of the contact layer 31 in the vertical direction.

A composition element of the contact layer 31 may include a germanium element. In some embodiments, composition elements of the contact layer 31 include a germanium element and a tantalum element.

In an example of these embodiments, in the contact layer 31, a ratio of a quantity of germanium elements to a quantity of tantalum elements is less than or equal to 50%. For example, in the contact layer 31, a ratio of mass of the germanium element to mass of the tantalum element is less than or equal to 50%. For example, in the contact layer 31, a ratio of a quantity of atoms of the germanium element to a quantity of atoms of the tantalum element is less than or equal to 50%. For example, the contact layer 31 includes at least one germanium layer and at least one tantalum layer, where the at least one germanium layer and the at least one tantalum layer are interleaved in a laminated manner, and a ratio of a total thickness of the at least one germanium layer to a total thickness of the at least one tantalum layer is less than or equal to 50%. The germanium layer and the tantalum layer are specifically described in the following Embodiment 2, and details are not described herein again.

The foregoing describes a relationship between the quantity of germanium elements and the quantity of tantalum elements in the contact layer 31 by using the ratio of mass, the ratio of the quantity of atoms, and the ratio of thickness as examples, but is not limited to the foregoing three. In another example, another quantization manner may be used to represent a relationship between the quantity of germanium elements and the quantity of tantalum elements, which is not listed one by one herein.

It may be clear that a thickness of the germanium layer refers to a height of the germanium layer in the vertical direction, and a thickness of the tantalum layer refers to a height of the tantalum layer in the vertical direction.

Composition elements of the contact layer 31 are described in more detail below, and details are not described herein again.

In some embodiments, the ohmic contact electrode 30 may further include a non-contact layer 32. The non-contact layer 32 is located on a side that is of the contact layer 31 and that is away from the epitaxial structure 20. The non-contact layer 32 may include a catalytic layer, a blocking layer, and a cap layer that are sequentially connected. The catalytic layer is in contact with the contact layer 31, the cap layer is located on a side that is of the non-contact layer 32 and that is away from the contact layer 31, and the blocking layer is located between the catalytic layer and the cap layer. The catalytic layer is configured to optimize element distribution between the contact layer 31 and the epitaxial structure 20, to further reduce an ohmic contact resistance. For example, the catalytic layer may be made of aluminum. The blocking layer can improve adhesion between the ohmic contact electrode 30 and the epitaxial structure 20, and reduce a possibility that the ohmic contact electrode 30 is detached from the epitaxial structure 20. For example, the blocking layer may be made of tantalum, titanium (Ti), nickel (Ni), or molybdenum (Mo). The cap layer may avoid or reduce external corrosion of the ohmic contact electrode 30. For example, the cap layer may be made of titanium nitride (TiN), or made of titanium tungstenide (TiW), or made of tungsten, or made of tantalum nitride (TaN).

Still referring to FIG. 2, the semiconductor device may further include a passivation layer 40. The passivation layer 40 covers a surface of the epitaxial structure 20, and is configured to protect the epitaxial structure 20 and shield external impact on the epitaxial structure 20. For example, the passivation layer 40 may be made of silicon nitride (SiN) or aluminum oxide ($Al_2O_3$).

The semiconductor device may further include a gate electrode 50, which may implement an electrical connection function. For example, the gate electrode 50 may be made of a nickel gold alloy (NiAu).

The foregoing example describes a general structure of the semiconductor device. The following describes a specific structure and a semiconductor device preparation method in different embodiments.

**Embodiment 1**

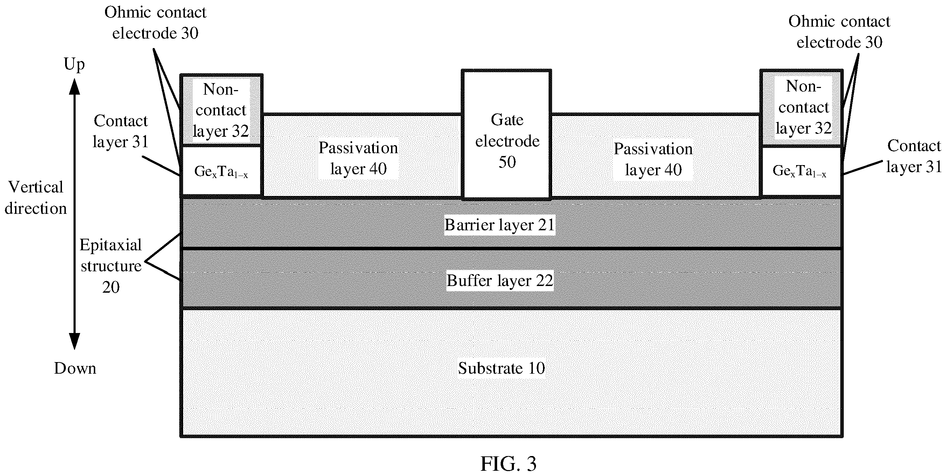

This embodiment provides a semiconductor device. As shown in FIG. 3, a contact layer 31 may be made of a germanium tantalum alloy. The germanium tantalum alloy is an alloy prepared by using a germanium element and a tantalum element as materials.

In an example, element composition of the germanium tantalum alloy may be shown in formula (I).

$$Ge_xTa_{1-x} \qquad (I).$$

In formula (I), x represents a proportion of germanium atoms in the alloy, and 1-x represents a proportion of tantalum atoms in the alloy, where x is less than 1 and greater than 0. In an example, x is less than or equal to 0.5 and is greater than or equal to 0.1. In an example, x is 0.2. In an example, x is 0.3. In an example, x is 0.4. In an example, x is 0.6. In an example, x is 0.7. In an example, x is 0.8. In an example, x is 0.9.

For another structure, refer to the foregoing description of the embodiment shown in FIG. 2. Details are not described herein again.

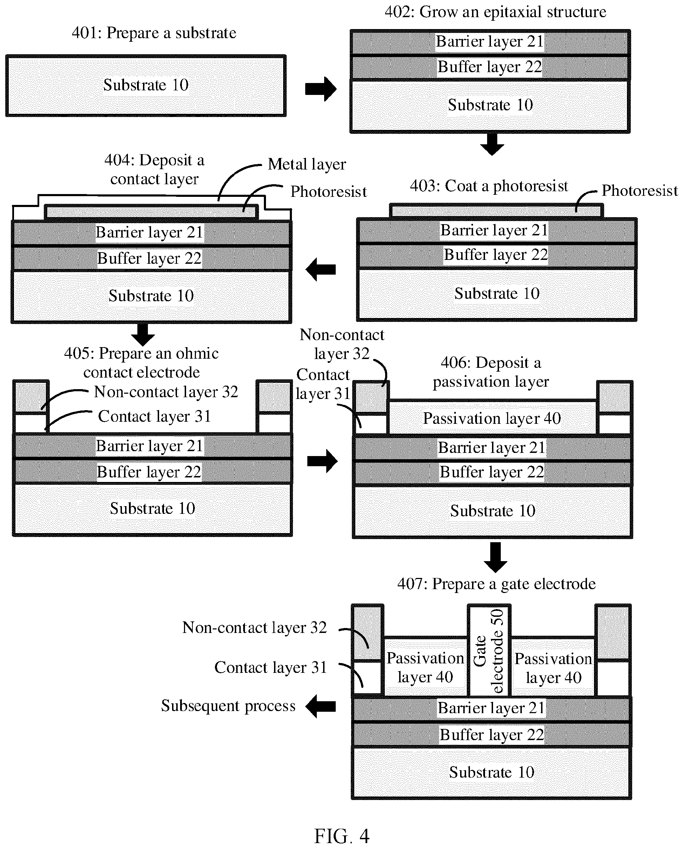

This embodiment further provides a semiconductor device preparation method. As shown in FIG. 4, the method may include the following steps.

Step 401: Prepare a substrate. A substrate 10 that can be used for epitaxial structure growth may be selected. For details of the substrate 10, refer to the description in the embodiment shown in FIG. 2, and details are not described herein again.

Step 402: Grow an epitaxial structure. A semiconductor epitaxial process may be used, and the substrate 10 is used as a substrate to grow the epitaxial structure.

In an illustrative example, chemical vapor deposition (chemical vapor deposition, CVD) may be used to grow the epitaxial structure.

In an illustrative example, a nucleation layer may be first grown on the substrate 10, and after an annealing process is performed, a buffer layer 22 is grown on the nucleation layer, and a barrier layer 21 is grown on the buffer layer 22.

For a specific process of growing the epitaxial structure, reference may be made to descriptions in the conventional technology, and details are not described herein again.

Step 403: Coat a photoresist. A contact area between the epitaxial structure 20 and an ohmic contact electrode may be preset. In other words, the contact area is used to contact or support the ohmic contact electrode. An area other than the contact area is coated with the photoresist.

Step 404: Deposit the contact layer 31 on the contact area.

As described above, the contact layer 31 is made of a $Ge_xTa_{1-x}$ alloy. Step 404 may have the following specific implementations.

In an implementation, a germanium tantalum alloy target material may be prepared by using a powder metallurgy or a melting method and using a germanium material and a tantalum material as raw materials. For example, purity of the germanium material is greater than 99.9999%. For example, purity of the tantalum material is greater than 99.95%.

After the germanium tantalum alloy target material is prepared, the germanium tantalum alloy target material may be deposited on the barrier layer 21 in a direct sputtering manner, to form a metal layer. For a specific implementation process of sputtering, refer to the description in the conventional technology. Details are not described herein again.

In an implementation, the germanium element and the tantalum element are deposited on the barrier layer 21 in a co-sputtering manner of a binary alloy of the germanium material and the tantalum material, to form a metal layer. For a specific implementation process of co-sputtering of the binary alloy, refer to descriptions in the conventional technology. Details are not described herein again. For example, purity of the germanium material is greater than 99.9999%. For example, purity of the tantalum material is greater than 99.95%.

Step 405: Prepare the ohmic contact electrode. A redundant part of the metal layer and the photoresist may be removed to prepare the contact layer 31. For a solution for removing the redundant part of the metal layer and the photoresist, refer to descriptions in the conventional technology. Details are not described herein again.

In some embodiments, the non-contact layer 32 may be deposited on the contact layer 31. For example, a composition material of a catalytic layer, a composition material of a blocking layer, and a composition material of a cap layer may be sequentially deposited, and then a non-contact layer 31 may be prepared by using a thermal annealing process. For a specific implementation process, refer to descriptions in the conventional technology. Details are not described herein.

Step 406: Deposit a passivation layer. After the ohmic contact electrode is prepared, the passivation layer may be deposited on the barrier layer 21. In an example, a preparation material of the passivation layer may be deposited on the barrier layer 21 through plasma-enhanced chemical vapor deposition (plasma-enhanced chemical vapor deposition, PECVD) or atomic layer deposition (atomic layer deposition, ALD), to prepare the passivation layer 40. For the preparation material of the passivation layer 40, refer to the foregoing description of the embodiment shown in FIG. 2.

Step 407: Prepare a gate electrode. Photoetching may be performed on the passivation layer 40 to obtain a gate electrode area, and a preparation material of the gate electrode is deposited in the gate electrode area to prepare the gate electrode 50. For details, refer to descriptions in the conventional technology. Details are not described again.

After step 407, a subsequent process of semiconductor device preparation may be performed. For details, refer to descriptions in the conventional technology. Details are not described herein again.

In the semiconductor device provided in this embodiment, the germanium element is added to a part that is of the ohmic contact electrode of the semiconductor device and that is in contact with a semiconductor, to provide more electrons that can cross a barrier between the contact layer and the epitaxial structure, to reduce the ohmic contact resistance. In addition, the germanium element helps improve surface quality of the contact layer, so that a contact interface between the contact layer and the epitaxial structure remains smooth. In addition, a melting point of the tantalum element is high, which can prevent deterioration of edge sharpness of a contact layer interface caused by annealing and maintain sharpness of the contact layer interface. The tantalum element can promote a more adequate phase reaction between composition elements of the contact layer. In addition, adding the tantalum element can reduce an annealing temperature of the ohmic contact electrode, so that the annealing temperature can reach below 600°C. This helps improve surface quality of the contact interface between the contact layer and the epitaxial structure, and improve thermal stability and reliability of the semiconductor device.

In addition, the semiconductor device preparation method provided in this embodiment is simple and easy to implement. This reduces production costs and a production cycle, and implements mass production of the semiconductor device.

**Embodiment 2**

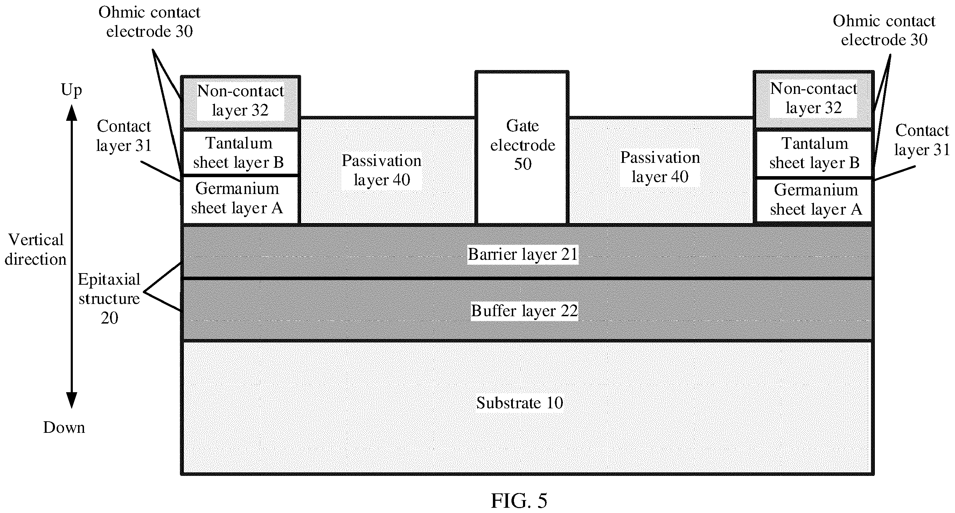

This embodiment provides a semiconductor device. As shown in FIG. 5, a contact layer 31 includes at least one germanium layer. The germanium layer refers to a sheet structure or a thin film prepared by using a germanium element. A germanium layer A in the at least one germanium layer is in contact with an epitaxial structure 20. For example, the germanium layer A is in contact with a barrier layer in the epitaxial structure 20. When the at least one germanium layer further includes another germanium layer, the another germanium layer is laminated on a side that is of the germanium layer A and that is away from the epitaxial structure 20.

In some embodiments, as shown in FIG. 5, the contact layer 31 includes at least one tantalum layer. The tantalum layer refers to a sheet structure or a thin film prepared by using the germanium element.

The at least one tantalum layer and the at least one germanium layer may be interleaved in a laminated manner on the epitaxial structure 20. For example, the at least one tantalum layer and the at least one germanium layer are interleaved in a laminated manner on the barrier layer 22.

Specifically, when the at least one germanium layer is the germanium layer A, the at least one tantalum layer is a tantalum layer B. The germanium layer A is laminated on the epitaxial structure 20. In other words, the germanium layer A is in contact with the epitaxial structure 20. The tantalum layer B is laminated on the germanium layer A.

When the at least one germanium layer includes a plurality of germanium layers, and the at least one tantalum layer includes a plurality of tantalum layers, the plurality of germanium layers and the plurality of tantalum layers may be interleaved in a laminated manner in a form of a germanium layer, a tantalum layer, a germanium layer, a tantalum layer, and... in a direction away from the epitaxial structure 20.

In some embodiments, a thickness of the contact layer 31 formed by interleaving the at least one germanium layer and the at least one tantalum layer in a laminated manner is less than or equal to 200 nm and is greater than 0. In an example, a thickness of the contact layer 31 is less than or equal to 100 nm and is greater than 0. In an example, a thickness of the contact layer 31 is greater than 6 nm and less than 60 nm. In an example, a thickness of the contact layer 31 is 10 nm. In an example, a thickness of the contact layer 31 is 20 nm. In an example, a thickness of the contact layer 31 is 30 nm. In an example, a thickness of the contact layer 31 is 40 nm. In an example, a thickness of the contact layer 31 is 50 nm.

In some embodiments, in the contact layer 31, a proportion of germanium and tantalum elements is less than or equal to 50% and is greater than 0. In an example, a proportion of germanium and tantalum elements is 10%. In an example, a proportion of germanium and tantalum elements is 20%. In an example, a proportion of germanium and tantalum elements is 30%. In an example, a proportion of germanium and tantalum elements is 40%.

In some embodiments, when the at least one germanium layer is prepared, a thickness of the at least one germanium layer is set to 1 to 10 nm. In other words, the at least one germanium layer is prepared based on the thickness of 1 to 10 nm. The 1 to 10 nm is a sum of thicknesses of all germanium layers in the at least one germanium layer.

In some embodiments, when the at least one tantalum layer is prepared, a thickness of the at least one tantalum layer is set to 5 to 50 nm. In other words, the at least one tantalum layer is prepared according to the thickness of 5 to 50 nm. The 5 to 50 nm is a sum of thicknesses of all tantalum layers in the at least one tantalum layer.

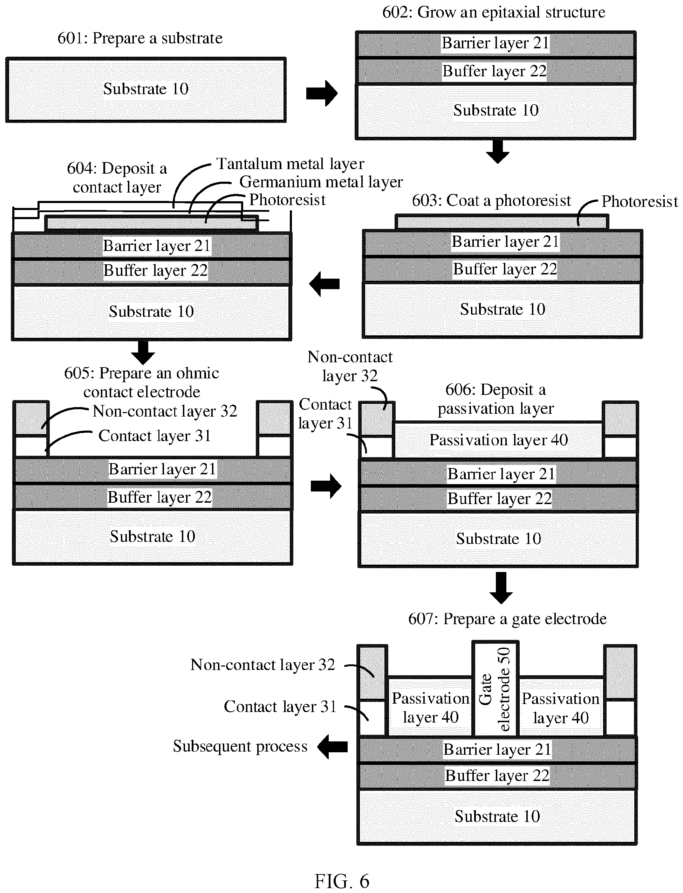

Embodiment 2 further provides a semiconductor device preparation method. Referring to FIG. 6, the method includes the following steps.

For steps 601 to 603, refer to the foregoing descriptions of steps 401 to 403 in FIG. 4. Details are not described herein again.

Step 604: Deposit a contact layer. A germanium metal layer may be first deposited on the epitaxial structure 20 by using a germanium material in a sputtering manner. Then, a tantalum material is deposited on the germanium metal layer in a sputtering manner, to form a tantalum metal layer. By analogy, the contact layer is deposited based on a specified quantity and total thickness of the germanium layers and a specified quantity and total thickness of the tantalum layers.

For steps 605 to 607, refer to the foregoing descriptions of step 405 to step 407. Details are not described herein again.

In the semiconductor device prepared in Embodiment 2, an ohmic contact electrode is in contact with the epitaxial structure by using the germanium layer, so that an interface with good surface quality may be formed between the ohmic contact electrode and the epitaxial structure. In particular, compared with a solution of depositing or injecting silicon on the epitaxial structure, the germanium layer or a germanium thin film deposited on the epitaxial structure has a better appearance. An appearance of a silicon thin film with a thickness of 8 nm deposited on the epitaxial structure and an appearance of a germanium thin film with a thickness of 8 nm deposited on the epitaxial structure are compared. On the epitaxial structure, a 4 nm silicon thin film is deposited first, and then an appearance of a germanium thin film with a thickness of 4 nm and an appearance of the epitaxial structure are deposited. It is found that a surface of the silicon film has a poor appearance, and there is an obvious overheating point on the surface of the silicon film after annealing. However, the deposited germanium film has a good appearance, the metal surface after annealing is even and flat, and an edge sharpness becomes better. This can reduce the ohmic contact resistance and improve thermal stability and reliability of the semiconductor device.

In addition, an electronic sequence number 32 of the germanium element is adjacent to a gallium atomic sequence number. Therefore, when the semiconductor in contact with the germanium layer is AlGaN or another semiconductor including gallium, the germanium and the gallium in the semiconductor diffuse with each other, which facilitates forming a conductive area. In addition, after the germanium layer is annealed, a surface appearance of the germanium layer is good, so that a surface appearance of a contact interface between the germanium layer and the semiconductor is good, to further reduce the ohmic contact resistance. In addition, the tantalum element is introduced into the contact layer of the ohmic contact electrode, so that an ohmic annealing temperature can be reduced to below 600°C.

In addition, in this embodiment, in a metal laminating manner, the germanium layer becomes an intermediate layer between the tantalum layer and a barrier layer 21, so that an electronic tunneling effect can be generated between the germanium and the barrier layer 21, to enhance a conductive effect, avoid direct contact between the tantalum and the barrier layer 21, reduce the ohmic contact resistance, and improve an ohmic contact interface. In this embodiment, the contact layer 31 may include a plurality of germanium layers and a plurality of tantalum layers that are interleaved in a laminated manner, and adjacent germanium layer and tantalum layer may diffuse with each other. Therefore, an alloy is more easily formed, and performance of the contact layer is improved.

In addition, the semiconductor device preparation method provided in this embodiment is simpler and easier to implement. This reduces production costs and a production cycle, and implements mass production of the semiconductor device.

## Embodiment 3

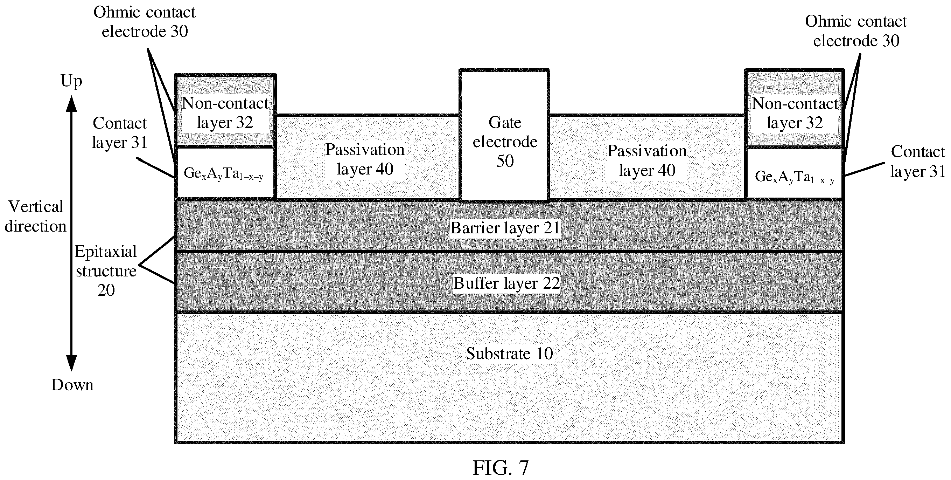

This embodiment provides a semiconductor device. As shown in FIG. 7, a contact layer 31 may include a germanium element, a tantalum element, and an A element. In an example, the contact layer 31 may be made of an alloy including the germanium element, the tantalum element, and the A element. Element composition of the alloy including the germanium element, the tantalum element, and the A element is shown in formula (II).

$$Ge_xA_yTa_{1-x-y} \qquad (II)$$

In formula (II), x represents a proportion of germanium atoms in the alloy, y represents a proportion of atoms of the A element in the alloy, and 1-x-y represents a proportion of tantalum atoms in the alloy, where $1>x+y$, $x>0$, and $y>0$. In an example, the A element is Ti. In an example, the A element is Al. In an example, the A element is Pt. In an example, the A element is Au. In an example, the A element is Ni. In an example, the A element is Mo. In an example, the A element is W.

Element A can catalyze Ge and Ta to form an alloy with more uniform atomic distribution. The A element may further optimize element distribution between a barrier layer and a contact layer of an ohmic contact electrode, increase a large band gap width of the barrier layer, increase a concentration of 2DEG, and reduce an ohmic contact resistance. For example, the A element is Al, and the barrier layer 21 is AlGaN. The A element may enable an N element in AlGaN to diffuse to $Ge_xA_yTa_{1-x-y}$, so that content of the N element in AlGaN is reduced, and an Al component is increased, to increase the large band gap width of the barrier layer of AlGaN, increase the concentration of 2DEG, and reduce the ohmic contact resistance.

In an illustrative example, $0.5 \geq x \geq 0.1$, $0.1 \geq y > 0$. In an example, x is 0.1. In an example, x is 0.2. In an example, x is 0.3. In an example, x is 0.4. In an example, x is 0.5. In an example, y is 0.05. In an example, y is 0.1.

The semiconductor device preparation method provided in this embodiment may be implemented with reference to the preparation method provided in Embodiment 1. Different from Embodiment 1, step 405 used in this embodiment may have the following specific implementations.

In an implementation, a $Ge_xA_yTa_{1-x}$ alloy target material may be prepared by using a powder metallurgy or a melting method and using a germanium material, a tantalum material, and an A element material as raw materials. For example, purity of the germanium material is greater than 99.9999%. For example, purity of the tantalum material is greater than 99.95%. After the $Ge_xA_yTa_{1-x}$ alloy target material is prepared, the $Ge_xTA_ya_{1-x}$ alloy target material may be deposited on the barrier layer 21 in a direct sputtering manner, to deposit the contact layer. For a specific implementation process of sputtering, refer to the description in the conventional technology. Details are not described herein again.

In an implementation, the contact layer deposition is performed in a manner of co-sputtering of a ternary alloy of the germanium material, the tantalum material, and the A element material. For a specific implementation process of co-sputtering of the ternary alloy, refer to the description in the conventional technology. Details are not described herein again. For example, purity of the germanium material is greater than 99.9999%. For example, purity of the tantalum material is greater than 99.95%.

In addition, in this embodiment, the ohmic contact electrode may be annealed in an atmosphere of nitrogen ($N_2$), or annealed in an atmosphere of a mixture of nitrogen and hydrogen ($H_2$).

For another preparation process, refer to the foregoing description of Embodiment 1, and details are not described herein again.

In this embodiment, the contact layer of the ohmic contact electrode uses a $Ge_xA_yTa_{1-x-y}$ ternary alloy, and the arrangement between different elements is adjusted, to further reduce the ohmic contact resistance, improve an appearance of a contact interface (the contact interface between the contact layer and the epitaxial structure), and improve thermal stability and reliability of the semiconductor device. In addition, the semiconductor device preparation method is simple and easy to implement, and can implement rapid mass production of the semiconductor device.

## Embodiment 4

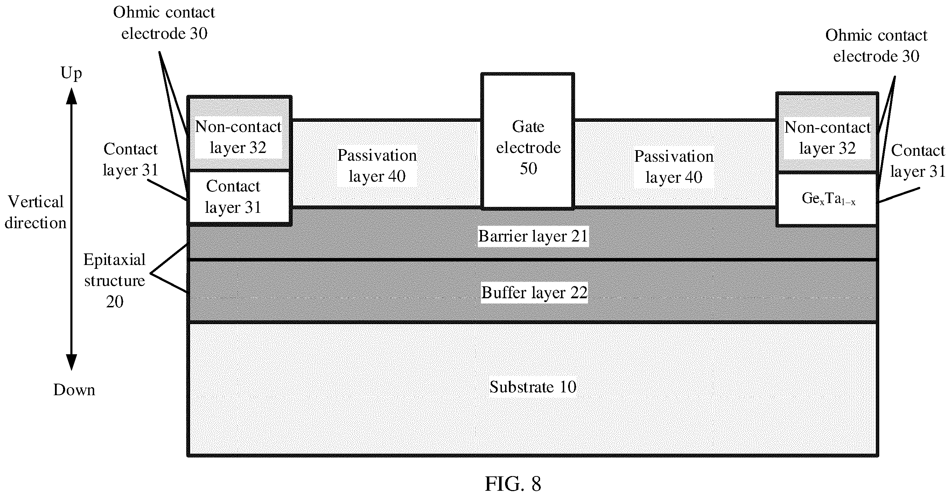

This embodiment provides a semiconductor device. As shown in FIG. 8, in the semiconductor device, a distance between a contact layer 31 and a buffer layer 22 in a vertical direction is less than a height of a barrier layer 21 in the vertical direction. The height of the barrier layer 21 in the vertical direction may also be referred to as a thickness of the barrier layer 21. In this embodiment, the contact layer 31 is specifically in contact with the barrier layer 21. The barrier layer 21 includes a contact part and a non-contact part. The contact part is a part that is of the barrier layer 21 and that is in contact with the contact layer 31. Alternatively, the contact layer 31 is specifically in contact with an upper surface of the contact part. The upper surface of the contact part is a surface that is of the contact part and that is away from the buffer layer 22. The non-contact part is a part that is of the barrier layer 21 and that is not in contact with the contact layer 31. In other words, an upper surface of the non-contact part is not in contact with the contact layer 31, for example, an area that is in the barrier layer and that is in contact with a passivation layer 40 or a gate electrode 50. The upper surface of the non-contact part is a surface that is of the non-contact part and that is away from the buffer layer 22. As shown in FIG. 8, a height of the contact part in the vertical direction is less than a height of the non-contact part in the vertical direction, and the height of the contact part in the vertical direction is not zero.

For a structure of the contact layer 31, refer to the description in Embodiment 1, Embodiment 2, or Embodiment 3. Details are not described herein again.

During preparation of the semiconductor device provided in this embodiment, groove etching may be performed on a preset part on the barrier layer, to reduce a thickness of the preset part. The preset part after the groove etching is the contact part described above. After acid cleaning processing is performed on the contact part, a contact layer target material may be sputtered onto the upper surface of the contact part, to prepare the contact layer 31. For a preparation manner of another component or structure of the semiconductor device, refer to the foregoing description of Embodiment 1, Embodiment 2, or Embodiment 3. Details are not described herein again.

In the semiconductor device provided in this embodiment, the contact layer 31 is closer to a two-dimensional electronic gas. This increases a probability of electron tunneling between an ohmic contact electrode and the two-dimensional electronic gas, and reduces an ohmic contact resistance.

**Embodiment 5**

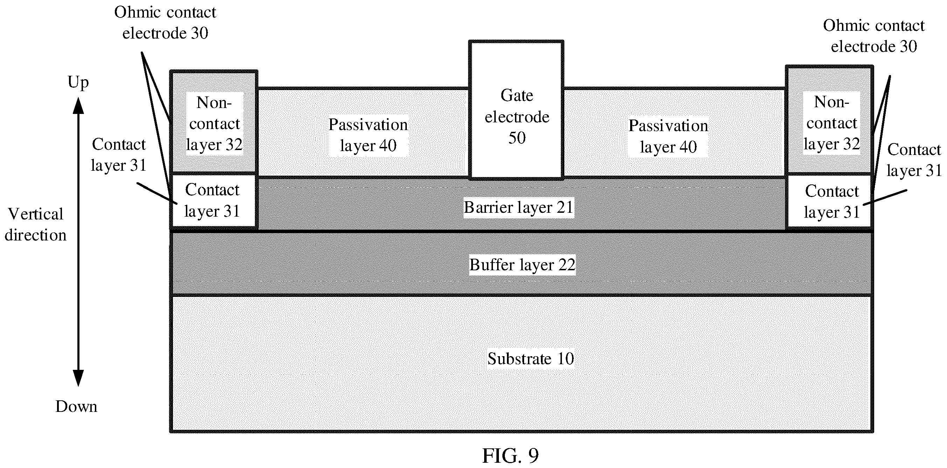

This embodiment provides a semiconductor device. As shown in FIG. 9, in the semiconductor device, a contact layer 31 is specifically in contact with a buffer layer 22. In other words, a thickness of the barrier layer 21 below the contact layer 31 is zero.

For a structure of the contact layer 31, refer to the description in Embodiment 1, Embodiment 2, or Embodiment 3. Details are not described herein again.

The buffer layer 22 includes a contact part and a non-contact part. An upper surface of the contact part is in contact with the contact layer 31. An upper surface of the contact part refers to a surface that is of the contact part and that is away from a substrate 10. An upper surface of the non-contact part is not in contact with the contact layer 31. The upper surface of the non-contact part refers to a surface that is of the non-contact part and that is away from the substrate 10.

In an illustrative example, a height of the contact area in a vertical direction is equal to a height of the non-contact area in the vertical direction. During preparation of the semiconductor device, full etching may be performed on the barrier layer 21, to expose an upper surface of the buffer layer 22. The upper surface of the buffer layer 22 means a surface that is of the buffer layer 22 and that is away from the substrate 10. The contact layer 31 may be deposited on the upper surface exposed by the buffer layer 22. For a solution of depositing the contact layer 31 and a preparation manner of another component or structure of the semiconductor device, refer to the foregoing description of Embodiment 1, Embodiment 2, or Embodiment 3. Details are not described herein again.

In this illustrative example, the contact layer 31 is closer to a two-dimensional electron gas, and a barrier between the contact layer 31 and the buffer layer 22 is lower than a barrier between the contact layer 31 and the barrier layer 21. This facilitates electron tunneling, increases a probability of electron tunneling between an ohmic contact electrode and the two-dimensional electron gas, and reduces an ohmic contact resistance.

In an illustrative example, the height of the contact area in the vertical direction is less than the height of the non-contact area in the vertical direction. During preparation of the semiconductor device, the barrier layer 21 may be fully etched to expose a part of the buffer layer 22. Then, groove etching is performed on the exposed part, to reduce a height of the exposed part in the vertical direction, to obtain the contact part. The contact layer 31 may be deposited in the contact part. For a solution of depositing the contact layer 31 and a preparation manner of another component or structure of the semiconductor device, refer to the foregoing description of Embodiment 1, Embodiment 2, or Embodiment 3. Details are not described herein again.

In the illustrative example, the contact layer 31 is closer to the two-dimensional electronic gas, and even directly contacts the two-dimensional electronic gas. This further increases probability of electron tunneling between the ohmic contact electrode and the two-dimensional electronic gas, and reduces the ohmic contact resistance.

In conclusion, the semiconductor device provided in embodiments of this application has a low ohmic contact resistance, and has high thermal stability and reliability.

In the descriptions of this specification, the described specific features, structures, materials, or characteristics may be combined in a proper manner in any one or more of embodiments or examples.

It may be understood that in the descriptions of embodiments of this application, words such as "example", "for example", or "such as" are used to represent giving an example, an illustration, or a description. Any embodiment or design scheme described as "example", "for example", or "such as" in embodiments of this application should not be explained as being more preferred or having more advantages than another embodiment or design scheme. Exactly, use of the word as "example", "for example", or "such as" is intended to present a related concept in a specific manner.

The term "and/or" in embodiments of this application describes only an association relationship for describing associated objects and represents that three relationships may exist. For example, A and/or B may represent the following three cases: Only A exists, both A and B exist, and only B exists. In addition, unless otherwise specified, the term "a plurality of" means two or more than two. For example, a plurality of systems refer to two or more systems, and a plurality of terminals refer to two or more terminals.

Moreover, the terms "first" and "second" are merely intended for a purpose of description, and shall not be understood as an indication or implication of relative importance or implicit indication of an indicated technical feature. Therefore, a feature limited by "first" or "second" may explicitly or implicitly include one or more features. The terms "include", "comprise", "have", and their variants all mean "include but are not limited to", unless otherwise specifically emphasized.

It should be noted that the foregoing embodiments are merely intended for describing the technical solutions of this application instead of limiting this application. Although this application is described in detail with reference to the foregoing embodiments, a person of ordinary skill in the art should understand that they may still make modifications to the technical solutions described in the foregoing embodiments or make equivalent replacements to some technical features thereof, without departing from the scope of the technical solutions of embodiments of this application.

The foregoing descriptions are merely specific implementations of this application, but are not intended to limit the protection scope of this application. Any variation or replacement readily figured out by a person skilled in the art within the technical scope disclosed in the present invention shall fall within the protection scope of this application. Therefore, the protection scope of this application shall be subject to the protection scope of the claims.

**Claims**

1. A semiconductor device, comprising:

   a substrate;
   an epitaxial structure disposed on the substrate;
   a passivation layer disposed on the epitaxial structure; and
   an ohmic contact electrode disposed in parallel with the passivation layer on the epitaxial structure, wherein the ohmic contact electrode comprises a non-contact layer and a contact layer that are disposed in a laminated manner, the contact layer is in contact with the epitaxial structure, and composition elements of the contact layer comprise a germanium element and a tantalum element.

2. The semiconductor device according to claim 1, wherein the contact layer comprises a germanium tantalum alloy.

3. The semiconductor device according to claim 2, wherein element composition of the germanium tantalum alloy is shown in formula (I):

$$Ge_xTa_{1-x} \qquad (I),$$

   wherein
   $0.5 \geq x \geq 0.1$.

4. The semiconductor device according to claim 1, wherein the contact layer comprises at least one germanium layer, and the contact layer is in contact with the epitaxial structure by using a first germanium layer of the at least one germanium layer.

5. The semiconductor device according to claim 4, wherein the contact layer further comprises at least one tantalum layer, wherein the at least one germanium layer and the at least one tantalum layer are interleaved in a laminated manner.

6. The semiconductor device according to any one of claims 1 to 5, wherein a ratio of a quantity of germanium elements to a quantity of tantalum elements is less than or equal to 50%.

7. The semiconductor device according to claim 1, wherein the contact layer comprises elements Ge, Ta, and A, wherein the A element is any one of the following:
Ti, Al, Pt, Au, Ni, Mo, and W.

8. The semiconductor device according to claim 7, wherein the contact layer comprises an alloy formed by the elements Ge, Ta, and A.

9. The semiconductor device according to claim 8, wherein element composition of the alloy formed by the elements Ge, Ta, and A is shown in formula (II):

$$Ge_xA_yTa_{1-x-y} \text{ alloy} \qquad (II),$$

wherein
$0.5 \geq x \geq 0.1$, and $0.1 \geq y > 0$.

10. The semiconductor device according to any one of claims 1 to 9, wherein the epitaxial structure comprises:

   a first semiconductor layer located above the substrate; and
   a second semiconductor layer located between the first semiconductor layer and the substrate and in contact with the first semiconductor layer, wherein a two-dimensional electron gas is disposed on a side that is of the second semiconductor layer and that is close to the first semiconductor layer, wherein
   a distance between the contact layer and the second semiconductor layer in a vertical direction is less than a height of the first semiconductor layer in the vertical direction.

11. The semiconductor device according to any one of claims 1 to 9, wherein the epitaxial structure comprises:

   a first semiconductor layer located above the substrate; and
   a second semiconductor layer located between the first semiconductor layer and the substrate and in contact with the first semiconductor layer, wherein a two-dimensional electron gas is disposed on a side that is of the second semiconductor layer and that is close to the first semiconductor layer, wherein
   the contact layer runs through the first semiconductor layer and is in contact with the second semiconductor layer.

12. The semiconductor device according to claim 11, wherein a distance between the contact layer and the substrate in a vertical direction is less than a height of the second semiconductor layer in the vertical direction.

13. The semiconductor device according to any one of claims 10 to 12, wherein the second semiconductor layer is gallium nitride, and the first semiconductor layer is any one of AlGaN, InAlN, InAlGaN, AlN, ScAlN, and ScAlGaN; or the second semiconductor layer is gallium arsenide, and the first semiconductor layer is InGaAs or AlGaAs.

14. The semiconductor device according to any one of claims 1 to 13, wherein the non-contact layer comprises a blocking layer, and the blocking layer comprises any one of the tantalum element, a titanium element, a nickel element, and a molybdenum element.

15. The semiconductor device according to any one of claims 1 to 14, wherein the ohmic contact electrode is a source electrode or a drain electrode of the semiconductor device.

16. A semiconductor device preparation method, comprising:

   growing an epitaxial structure on a substrate; and
   depositing a contact layer of an ohmic contact electrode on the epitaxial structure, wherein composition elements of the contact layer comprise a germanium element and a tantalum element.

17. The method according to claim 16, wherein

   the epitaxial structure comprises a first semiconductor layer located above the substrate, and a second semiconductor layer located between the first semiconductor layer and the substrate and in contact with the first semiconductor layer, wherein a two-dimensional electron gas is disposed on a side that is of the second semiconductor layer and that is close to the first semiconductor layer;
   the method further comprises: etching a first part of the first semiconductor layer, to reduce a height of the first part in a vertical direction; and

the depositing a contact layer of an ohmic contact electrode on the epitaxial structure comprises: depositing the contact layer on the first part.

18. The method according to claim 16, wherein the epitaxial structure comprises: a first semiconductor layer located above the substrate, and a second semiconductor layer located between the first semiconductor layer and the substrate and in contact with the first semiconductor layer, wherein a two-dimensional electron gas is disposed on a side that is of the second semiconductor layer and that is close to the first semiconductor layer; and

the depositing a contact layer of an ohmic contact electrode on the epitaxial structure comprises: removing a first part that is in contact with a first area of the second semiconductor layer and that is in the first semiconductor layer; and

depositing the contact layer on the first area.

FIG. 1

Ohmic contact
electrode 30

Ohmic contact
electrode 30

Up

Vertical
direction

Down

| Non-contact layer 32 | | Gate electrode 50 | | Non-contact layer 32 |
| Contact layer 31 | Passivation layer 40 | | Passivation layer 40 | Contact layer 31 |

Epitaxial structure 20

Substrate 10

Left ⟷ Right

Horizontal direction

FIG. 2

EP 4 372 826 A1

FIG. 3

**401: Prepare a substrate**

Substrate 10

**402: Grow an epitaxial structure**

Barrier layer 21
Buffer layer 22
Substrate 10

**404: Deposit a contact layer** — Metal layer — Photoresist

Barrier layer 21
Buffer layer 22
Substrate 10

**403: Coat a photoresist** — Photoresist

Barrier layer 21
Buffer layer 22
Substrate 10

**405: Prepare an ohmic contact electrode**
— Non-contact layer 32
— Contact layer 31

Barrier layer 21
Buffer layer 22
Substrate 10

Non-contact layer 32
Contact layer 31

**406: Deposit a passivation layer**

Passivation layer 40
Barrier layer 21
Buffer layer 22
Substrate 10

**407: Prepare a gate electrode**

Non-contact layer 32
Contact layer 31
Subsequent process

Passivation layer 40 | Gate electrode 50 | Passivation layer 40
Barrier layer 21
Buffer layer 22
Substrate 10

FIG. 4

FIG. 5

601: Prepare a substrate

602: Grow an epitaxial structure

| Substrate 10 |

| Barrier layer 21 |
| Buffer layer 22 |
| Substrate 10 |

604: Deposit a contact layer — Tantalum metal layer / Germanium metal layer / Photoresist

603: Coat a photoresist — Photoresist

| Barrier layer 21 |
| Buffer layer 22 |
| Substrate 10 |

| Photoresist |
| Barrier layer 21 |
| Buffer layer 22 |
| Substrate 10 |

605: Prepare an ohmic contact electrode — Non-contact layer 32 / Contact layer 31

Non-contact layer 32
Contact layer 31

606: Deposit a passivation layer

| Barrier layer 21 |
| Buffer layer 22 |
| Substrate 10 |

| Passivation layer 40 |
| Barrier layer 21 |
| Buffer layer 22 |
| Substrate 10 |

607: Prepare a gate electrode

Non-contact layer 32
Contact layer 31
Subsequent process

| Passivation layer 40 | Gate electrode 50 | Passivation layer 40 |
| Barrier layer 21 |
| Buffer layer 22 |
| Substrate 10 |

FIG. 6

Ohmic contact
electrode 30

Ohmic contact
electrode 30

Up

Contact
layer 31

Non-contact
layer 32

Gate
electrode
50

Non-contact
layer 32

Contact
layer 31

$Ge_xA_yTa_{1-x-y}$

Passivation
layer 40

Passivation
layer 40

$Ge_xA_yTa_{1-x-y}$

Vertical
direction

Barrier layer 21

Epitaxial
structure
20

Buffer layer 22

Substrate 10

Down

FIG. 7

EP 4 372 826 A1

FIG. 8

EP 4 372 826 A1

EP 4 372 826 A1

Ohmic contact
electrode 30

Ohmic contact
electrode 30

Up

Non-
contact
layer 32

Gate
electrode
50

Non-
contact
layer 32

Passivation
layer 40

Passivation
layer 40

Contact
layer 31

Contact
layer 31

Contact
layer 31

Vertical
direction

Contact
layer 31

Barrier layer 21

Buffer layer 22

Substrate 10

Down

FIG. 9

**EP 4 372 826 A1**

## INTERNATIONAL SEARCH REPORT

| International application No. |
|---|
| **PCT/CN2022/110564** |

### A. CLASSIFICATION OF SUBJECT MATTER

H01L 29/45(2006.01)i; H01L 29/778(2006.01)i; H01L 21/285(2006.01)i; H01L 21/335(2006.01)i

According to International Patent Classification (IPC) or to both national classification and IPC

### B. FIELDS SEARCHED

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT; CNABS; WOTXT; EPTXT; USTXT; VEN; CNKI: 欧姆接触, 降低, 电阻, 锗, 钽, 合金, ohmic contact, reduce, decrease, resistance, germanium, Ge, Ta, tantalum, alloy, HEMT

### C. DOCUMENTS CONSIDERED TO BE RELEVANT

| Category* | Citation of document, with indication, where appropriate, of the relevant passages | Relevant to claim No. |
|---|---|---|
| X | JP 2006059933 A (MITSUBISHI CABLE IND. LTD.) 02 March 2006 (2006-03-02) description, paragraphs [0014]-[0033], and figure 1 | 1-18 |
| A | CN 111403281 A (SOUTHERN UNIVERSITY OF SCIENCE AND TECHNOLOGY) 10 July 2020 (2020-07-10) entire document | 1-18 |
| A | US 4186410 A (BELL TELEPHONE LABOR INC.) 29 January 1980 (1980-01-29) entire document | 1-18 |
| A | E.V.Erofeev et al. "Ohmic Contacts to n+-GaAs with Refractory Metal Sidewall Diffusion Barrier" *2015 International Siberian Conference on Control and Communications (SIBCON)*, 23 May 2015 (2015-05-23), pp. 1-5 | 1-18 |

☐ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 September 2022** | **28 September 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**26**

INTERNATIONAL SEARCH REPORT
Information on patent family members

International application No.

**PCT/CN2022/110564**

| Patent document cited in search report | | | Publication date (day/month/year) | Patent family member(s) | | | Publication date (day/month/year) |
|---|---|---|---|---|---|---|---|
| JP | 2006059933 | A | 02 March 2006 | JP | 4733371 | B2 | 27 July 2011 |
| CN | 111403281 | A | 10 July 2020 | WO | 2021189658 | A1 | 30 September 2021 |
| US | 4186410 | A | 29 January 1980 | DE | 2925791 | A1 | 03 January 1980 |
| | | | | GB | 2024506 | A | 09 January 1980 |
| | | | | NL | 7904979 | A | 02 January 1980 |
| | | | | FR | 2430090 | A1 | 25 January 1980 |
| | | | | CA | 1125924 | A | 15 June 1982 |
| | | | | JP | S554999 | A | 14 January 1980 |
| | | | | GB | 2024506 | B | 27 April 1983 |
| | | | | BE | 877189 | A1 | 15 October 1979 |
| | | | | IT | 1121920 | B | 23 April 1986 |
| | | | | DE | 2925791 | C2 | 29 May 1991 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110913394X